Europäisches Patentamt

**European Patent Office**

Office européen des brevets

(11) Numéro de publication: **0 309 038 B1**

## FASCICULE DE BREVET EUROPEEN

(45) Date de publication de fascicule du brevet: **09.06.93**  (51) Int. Cl.⁵: **H04L 27/22**, H03L 7/08

(21) Numéro de dépôt: **88202004.3**

(22) Date de dépôt: **15.09.88**

(54) Circuit de récupération de l'onde porteuse de systèmes de transmissions numériques.

(30) Priorité: **25.09.87 FR 8713292**

(43) Date de publication de la demande:
**29.03.89 Bulletin  89/13**

(45) Mention de la délivrance du brevet:
**09.06.93 Bulletin  93/23**

(84) Etats contractants désignés:
**DE FR GB IT SE**

(56) Documents cités:
**FR-A- 2 552 959**
**US-A- 4 100 503**
**US-A- 4 338 574**

(73) Titulaire: **LABORATOIRES D'ELECTRONIOUE PHILIPS**
**3, Avenue Descartes**
**F-94450 Limeil-Brévannes(FR)**
(84) Etats contractants désignés:
**FR**

(73) Titulaire: **N.V. Philips' Gloeilampenfabrieken**
**Groenewoudseweg 1**
**NL-5621 BA Eindhoven(NL)**
(84) Etats contractants désignés:
**DE GB IT SE**

(72) Inventeur: **Hikmet, Sari, c/o Société Civile S.P.I.D.**
**209, rue de l'Université**
**F-75007 Paris(FR)**

(74) Mandataire: **Landousy, Christian et al**
**Société Civile S.P.I.D. 156, Boulevard Haussmann**
**F-75008 Paris (FR)**

EP 0 309 038 B1

## Description

L'invention concerne un circuit de récupération de l'onde porteuse d'une onde modulée numériquement de symétrie de phase $2\pi/M$, où M est l'ordre de la symétrie de la constellation des états, muni de moyens d'acquisition automatiques et rapides comprenant un oscillateur commandable en tension ayant une sortie délivrant ladite onde porteuse et une entrée de commande sur laquelle est appliqué un signal d'erreur $\epsilon(\phi)$ afin de modifier la phase de l'oscillateur et l'asservir à celle de l'onde modulée numériquement, celle-ci étant introduite :

. sur une première voie comprenant en série :
- un démodulateur recevant l'onde modulée et la sortie de l'oscillateur, le démodulateur étant suivi d'un filtre passe-bas qui délivre un signal filtré X,

. sur une seconde voie comprenant en série :
- un déphaseur à 90° du signal de l'oscillateur,
- un démodulateur recevant l'onde modulée et la sortie du déphaseur, le démodulateur étant suivi d'un filtre passe-bas qui délivre un signal filtré Y,

les deux voies entrant avec une horloge de base H (horloge symbole récupérée), dans un dispositif de comparaison de phase qui détermine un signal de comparaison et le valide à l'aide d'une horloge d'échantillonnage à cadence variable qui reproduit l'horloge de base H en excluant certains fronts, le signal de comparaison étant mémorisé puis introduit dans un filtre amplificateur qui délivre le signal d'erreur $\epsilon(\phi)$ de commande de l'oscillateur, la représentation graphique des états d'une constellation étant définis en coordonnées polaires par la fonction $F(A,\Phi)$ où A est l'amplitude et $\Phi$ la phase de chaque point de la constellation, et $\phi$ étant l'écart de phase entre l'onde modulée reçue et le point de la constellation correspondant.

L'invention concerne également les dispositifs où un circuit de récupération de l'onde porteuse trouve son application, tels que les dispositifs de transmission numérique, en particulier ceux pour lesquels une information, après avoir été transmise par modulation d'une onde électromagnétique est restituée par démodulation cohérente. Ces dispositifs trouvent leur application dans les modems de transmission de données, les faisceaux hertziens, les systèmes de communications spatiales ou optiques dans le cas de liaisons hétérodynes.

Pour effectuer la démodulation cohérente, la phase de l'onde porteuse est restituée en général à l'aide d'un oscillateur placé dans une boucle de récupération de porteuse. Cet oscillateur est commandé en tension par une version filtrée du signal de sortie d'un comparateur de phase qui détecte l'écart de phase entre l'oscillateur et l'onde porteuse d'émission.

Pour des modulations numériques à grand nombre d'états, l'écart de phase entre l'oscillateur et l'onde porteuse doit être impérativement limité à des petites valeurs. La bande de bruit de la boucle de récupération est alors réduite à l'aide d'un filtrage passe-bas étroit. Cette réduction entraîne un faible bruit de phase, et aussi une diminution considérable de la plage d'acquisition. Pour surmonter cet inconvénient on utilise des dispositifs d'aide à l'acquisition.

Parmi ces dispositifs on utilise couramment des discriminateurs de fréquence qui génèrent une tension qui dépend de l'écart de fréquence entre l'oscillateur et l'onde porteuse tel que celui décrit dans le brevet français n° 2 552 959 délivré le 25 octobre 1985. Ce brevet concerne un circuit de récupération de porteuse pour des modulations numérique de symétrie $2\pi/M$ dans lequel un échantillonnage à cadence variable de la sortie du comparateur de phase transforme celui-ci en discriminateur de fréquence. Cette propriété est obtenue par l'élimination des transitions par zéro de la sortie du comparateur de phase qui surviennent lorsque l'erreur de phase entre l'oscillateur et l'onde porteuse est égale

$$\text{à } \frac{\pi}{M} + \frac{2k\pi}{M},$$

où k et M sont des nombres entiers.

Or en présence de modulations numériques d'amplitude de deux porteuses en quadrature à multi-états, le discriminateur de fréquence, décrit dans ce brevet, présente des inconvénients, son gain se trouvant dégradé, car il subsiste sur la sortie échantillonnée du comparateur de phase des transitions par zéro qui sont prises en compte, et qui ne correspondent pas à une erreur de phase nulle. En effet, ce discriminateur de fréquence génère une horloge d'échantillonnage, à partir d'une horloge de base H, dans laquelle certains fronts actifs de cette dernière sont éliminés. Cette élimination survient lorsque l'on détecte des transitions par zéro pour lesquelles l'écart de phase entre l'oscillateur et l'onde porteuse est égal à

$$\text{à } \frac{\pi}{M} + \frac{2k\pi}{M}.$$

Mais il apparaît à l'expérience, dans des modulations de phase et d'amplitude, qu'il existe d'autres transitions par zéro à la sortie du comparateur de phase qui mettent en défaut une acquisition correcte de l'onde porteuse. Par exemple dans le cas d'une modulation MAQ 16, la sortie des comparateurs de phase couramment utilisés présentent des transitions par zéro alors que l'écart de phase est égal à $\phi$ = arc tan (1/3) pour les états (3,1), (-1,3), (-3,-1), (1,-3). D'autres états présentent un comportement analogue. De plus, avec un nombre d'états de modulation plus important, le nombre de ces transitions par zéro indésirables va croître, et ceci entraîne une détérioration des performances du discriminateur.

Le but de l'invention est donc d'éviter cette dégradation en supprimant la prise en compte de toutes les transitions par zéro indésirables.

Pour cela l'invention telle que définie dans le préambule est remarquable en ce que le circuit de récupération de l'onde porteuse possède un dispositif de comparaison de phase qui opère soit en détecteur de phase soit en détecteur de fréquence à l'aide d'un signal externe d'accrochage/décrochage ACC et pour cela comprend des moyens de sélection des points reçus à l'aide de zones de sélection attenantes à certains états de la constellation, les zones, formant des portions d'anneaux, étant déterminées par l'intersection :

- premièrement des secteurs angulaires ($-\theta$, $+\theta$) correspondant à un écart de phase $\phi$ entre l'onde modulée reçue et le point de la constellation correspondant, tel que valeur absolue de $\phi < \theta$ où $\theta$ est une borne prédéterminée, chaque secteur ayant un axe de symétrie passant par les états diagonaux de la constellation, ces zones étant attenantes aux états diagonaux de la constellation pour lesquels il n'existe dans un quart de plan qu'un seul état ayant une amplitude A donnée,
- avec deuxièmement des cercles frontière, centrés sur l'origine de la constellation, de rayon

$$\frac{A1+A2}{2}$$

équidistants de deux cercles consécutifs joignant des états, l'un passant par les états à amplitude constante A1 et l'autre passant par les états à amplitude constante A2 consécutive, formant ainsi des anneaux, le point origine formant le cercle le plus intérieur, la frontière (cercle) extérieure étant bornée par l'amplitude maximale du signal détecté, les signaux X et Y servant à adresser une mémoire qui contient des informations d'appartenance se rapportant aux points reçus appartenant auxdites zones, le dispositif comprenant en outre des moyens de génération de l'horloge d'échantillonnage qui, en mode d'acquisition (décrochage) ne valident l'horloge de base H que pour ces zones sélectionnées et qui, en mode permanent (accrochage), valident tous les fronts de l'horloge H pour former l'horloge d'échantillonnage.

Dans le cas des états de la constellation pour lesquels l'angle minimum entre deux états adjacents sur le même cercle est inférieur à $\pi$/2, l'écart de phase tel que valeur absolue de $\phi < \theta$ est pris en compte, c'est-à-dire que la zone est sélectionnée, lorsque les signes de l'écart de phase sont les mêmes pour ces deux états adjacents.

Pour sélectionner les zones, les données X et Y servent à adresser une mémoire qui contient l'information d'appartenance ou non du point reçu à l'une des zones sélectionnées ainsi que l'amplitude et le signe de l'erreur qui s'y rapportent.

Ce dispositif est basé sur le stockage du signal d'erreur lorsque la valeur absolue de l'écart de phase $\phi$ dépasse une certaine valeur. Ce stockage s'effectue dans des bascules dont les données de sorties restent stables entre deux transitions par zéro reconnues valables. Ce signal d'erreur donne une information sur le signe de l'écart de fréquences entre l'oscillateur et l'onde porteuse. Ce stockage est effectué lorsque l'écart de phase à la sortie du comparateur est situé dans les zones de sélection définies.

Ce circuit de récupération de l'onde porteuse fait appel à un comparateur de phase qui possède les propriétés suivantes :

- sa caractéristique s'annule pour un écart de phase nul;
- sa caractéristique est périodique de période $2\pi$/M où M est l'ordre de symétrie de la modulation.

L'invention trouve son application pour des modulations numériques de symétrie de phase $2\pi$/M où M est l'ordre de symétrie de la constellation. Ainsi, une modulation de phase à 4 états présente une symétrie d'ordre 4, pour une modulation de phase à 8 états la symétrie est d'ordre 8, pour une modulation de phase et d'amplitude de deux porteuses en quadrature MAQ 16 la symétrie est d'ordre 4.

Mais l'invention présente ses avantages déterminants dans le cas d'une modulation d'amplitude et de phase à grand nombre d'états, de type $2^n$ (n entier), par exemple MAQ 64, MAQ 256. Elle présente également des avantages dans le cas des modulations d'amplitude et de phase pour lesquelles les écarts de phase entre certains points de la constellation sont inférieurs à la symétrie $2\pi$/M. Ainsi en modulation MAQ 64 la symétrie est de $\pi$/2, mais l'écart de phase entre les états ($+1$, $+1$) et ($+1$, $+5$) est de $\pi$/4-arc tan (1/5) donc inférieur à $\pi$/2.

Au cours de la période d'acquisition de la porteuse, l'onde modulée numériquement va pouvoir présenter tous les points de la constellation.

L'invention élimine donc tous les points reçus qui sont susceptibles de provoquer une acquisition érronée et n'utilise que des points qui sont susceptibles de provoquer une acquisition correcte.

Ainsi le circuit de récupération de l'onde porteuse selon l'invention possède des moyens de sélection des points reçus à l'aide de zones situées autour ou attenantes à certains états de la constellation.

Cette sélection s'effectue en déterminant l'appartenance ou la non-appartenance des points reçus à des zones pour lesquelles tout point reçu dans ces zones présente un écart de phase avec le point émis, tel que la valeur absolue de cet écart de phase reste inférieure à $2k\pi/M$ près, à une borne prédéterminée, ce qui permet d'éliminer les transitions par zéro à $k\pi/M$.

Ainsi l'information de phase prise en compte est seulement celle fournie par les points reçus dans ces zones. Pour déterminer l'appartenance à ces zones, puis la prise en compte de l'information y afférente, l'invention construit un dispositif de comparaison de phase qui s'insère dans un circuit de récupération d'une onde porteuse. Pour cela l'onde modulée numériquement est introduite simultanément sur deux démodulateurs, recevant également l'un la sortie de l'oscillateur et l'autre cette même sortie mais après avoir traversé un déphaseur de $\pi/2$ et délivrant respectivement les signaux démodulés $X_1$ et $Y_1$. Ceux-ci sont filtrés et fournissent respectivement les signaux X (en phase) et Y (en quadrature). Les signaux X et Y sont introduits dans le dispositif de comparaison de phase et servent à adresser une mémoire. Les données X et Y sont codées sur un certain nombre de bits dépendant de la précision avec laquelle les zones de sélection doivent être déterminées.

Le dispositif de comparaison de phase comprend deux convertisseurs analogique-numérique placés respectivement sur les voies en phase et en quadrature afin de recevoir les coordonnées cartésiennes X et Y du point reçu, les deux convertisseurs délivrant des données qui adressent une mémoire dont la sortie délivre p bits, l'un des bits étant un bit d'appartenance du point reçu à l'une des zones sélectionnées qui active une entrée d'une porte logique OU dont l'autre entrée reçoit un signal externe accrochage/décrochage, la sortie de la porte OU entrant dans une porte ET avec l'horloge de base H afin d'en supprimer les fronts lorsque, dans le mode d'acquisition le point reçu n'est pas dans une zone sélectionnée, et d'en valider tous les fronts dans l'état permanent, afin de constituer l'horloge d'échantillonnage qui active p-1 bascules qui reçoivent les p-1 bits issus de la mémoire, les sorties des bascules actionnant un convertisseur numérique-analogique qui délivre le signal d'erreur qui agit sur l'oscillateur à travers le filtre amplificateur.

L'invention sera mieux comprise à l'aide des dessins annexés, donnés à titre d'exemples non limitatifs, et qui représentent :

figure 1 : la représentation, dans un quart de plan, de la constellation d'une onde MAQ 64 où les zones sélectionnées selon l'invention sont représentées dans le cas d'une borne prédéterminée $\theta \leq 18,92°$,

figure 2 : une représentation analogue à celle de la figure 1 pour $18,92° < \theta \leq 22,62°$,

figure 3 : une représentation analogue à celle de la figure 1 pour $22,62° < \theta \leq 28,07°$,

figure 4 : un schéma du circuit de récupération de l'onde porteuse selon l'invention,

figure 5 : une représentation de la caractéristique du comparateur de phase et des variations avec la phase du signal de sortie du comparateur de phase avant et après mémorisation dans une bascule.

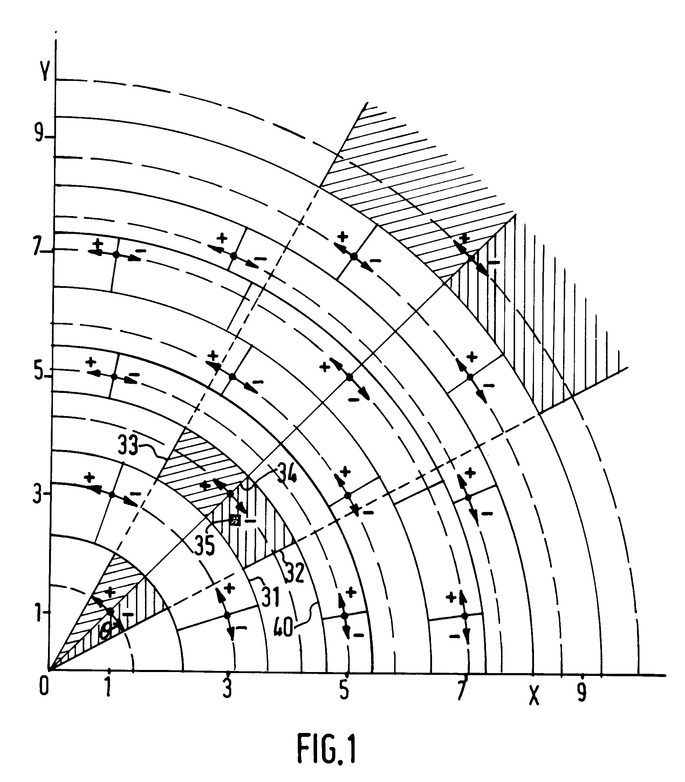

La figure 1 représente les 16 états d'une onde MAQ 64 représentée sur un quart de plan. Pour le plan total cette constellation a une symétrie $2\pi/M = \pi/2$. Selon la variation de phase de l'onde modulée incidente par rapport à l'oscillateur, pour un état particulier de la constellation, le point reçu va se déplacer sur un cercle centré en O et passant par l'état particulier ou à proximité de cet état particulier.

Entre deux états de module A1 et de module A2, les modules A1 et A2 étant consécutifs, par exemple les états (3,3) et (5,1), on définit un cercle frontière 40 équidistant des deux états tel que son rayon est

$$\frac{A1+A2}{2}.$$

Ceci permet de délimiter les zones d'appartenance des deux états en fonction de leur module respectif, et de définir des anneaux qui passent par tous les états ayant le même module. A l'intérieur de ces anneaux, un point peut être reçu avec une phase quelconque et se situer d'un côté ou de l'autre de l'état de la constellation, ce qui définit un écart de phase. On affecte le signe positif si la phase du point reçu est supérieure à celle du point de la constellation et le signe négatif dans le cas inverse. On effectue ainsi un découpage en coordonnées polaires de tout le plan de la constellation. Une rotation dans un sens ou dans l'autre caractérise le signe de l'écart de phase.

L'invention détermine une borne $\theta$ pour l'écart de phase $\phi$ au-delà de laquelle le point reçu n'est plus utilisé pour synchroniser la porteuse locale du circuit de récupération avec la porteuse émise. Les zones qui sont déterminées par l'invention sont ainsi bornées par les cercles frontières et par le secteur $(-\theta, +\theta)$. Ainsi autour de l'état (3,3) on a une zone de sélection, affectée d'un signe négatif, bornée par les cercles frontières 40 et 31 et les segments 32 et 34. De même il y a une zone de sélection avec un signe positif bornée par les mêmes cercles frontières et par les segments 33 et 34.

Ceci se présente de la même façon pour les états (1,1) et (7,7) avec les particularités suivantes. Pour l'état (1,1) le cercle frontière interne est constitué par l'origine. Pour l'état (7,7) le cercle frontière externe n'est pas défini, la borne étant constituée par l'amplitude maximale du point reçu.

Les états $(\pm 1, \pm 1)$, $(\pm 3, \pm 3)$, $(\pm 7, \pm 7)$ ont une symétrie égale à $\pi/2$ pour toute la constellation MAQ 64. Ils sont donc parfaitement déterminés dans un quart de plan de la constellation. Par contre il existe, dans un quart de plan, un état diagonal $(+5, +5)$ qui a une symétrie inférieure à $\pi/2$ et ne peut donc être différencié des états $(+7, +1)$ et $(+1, +7)$. Il n'existe donc pas dans l'anneau passant par ces trois états de zones de sélection possible.

L'invention détermine ainsi trois zones de sélection situées dans les anneaux définis autour des états diagonaux (1,1), (3,3), (7,7). Elles sont représentées par des surfaces hachurées sur la figure 1. Le signal incident, représenté en données cartésiennes par X et Y, permet de déterminer l'appartenance ou la non-appartenance du point reçu à l'une de ces zones. Les données X et Y sont codées sur plusieurs bits selon la précision recherchée. Si le point reçu se situe dans un élément de la zone de sélection tel que 35 il lui sera affecté une information de signe (ici le signe négatif) et une information d'amplitude caractérisant, si besoin est, son éloignement par rapport à l'état (3,3) afin de produire la correction de phase adéquate. Un codage simple peut être constitué de deux bits, l'un pour le signe et l'autre pour l'amplitude de la correction alors constante pour toute la zone.

Un codage plus élaboré peut être constitué de trois bits, l'un pour le signe et les deux autres bits pour définir plusieurs amplitudes de correction selon la position du point 35 dans la zone de sélection.

Ce codage est effectué pour toutes les zones de sélection. Les bornes $\theta$ peuvent d'ailleurs être différentes pour chacune des zones.

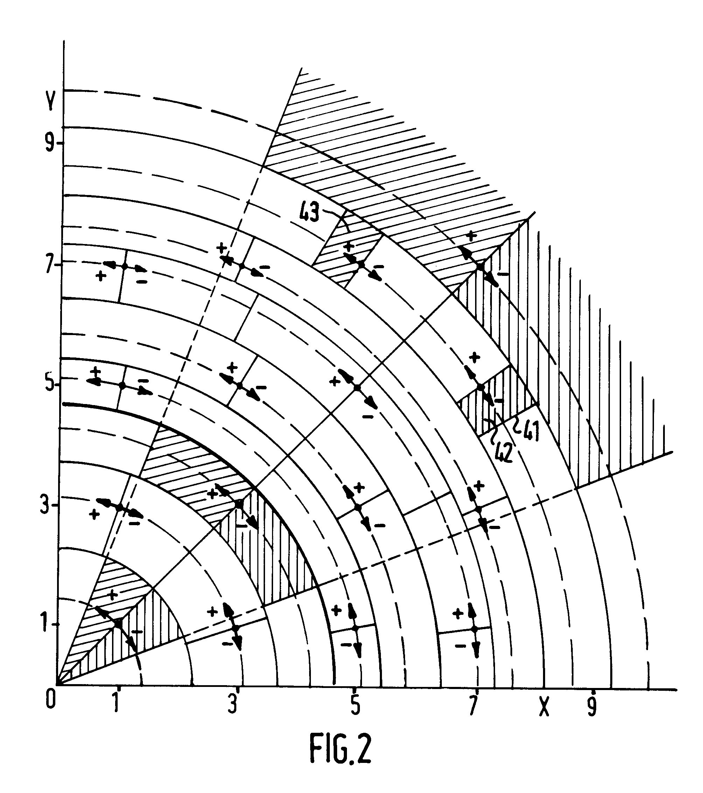

La figure 2 représente la même situation que celle de la figure 1 mais représentée avec une borne $\theta$ plus importante. Dans ce cas à partir par exemple de l'état $(+5, +7)$ on trace un secteur correspondant à l'écart de phase $\phi = -\theta$ définissant le segment 41 qui constitue ainsi l'étendue de la zone à signe négatif attenante à l'état (5, 7). Cette zone se superpose à la zone à signe négatif attenante à l'état (7, 5). Les deux zones à écart de phase de signe négatif se recouvrant, tout point reçu se situant dans la zone hachurée 42 détermine sans ambiguïté le signe de la correction. Par raison de symétrie une zone 43 est attenante à l'état (5, 7) avec une correction positive. Les deux zones de sélection 42 et 43 peuvent donc être utilisées pour déterminer le signe de l'écart de phase $\phi$ lorsque la valeur de $\theta$ dépasse 2 [45°-arc tan(5/7)] = 18,92° c'est-à-dire lorsque la zone négative attenante à l'état (5, 7) recouvre la zone négative attenante à l'état (7, 5).

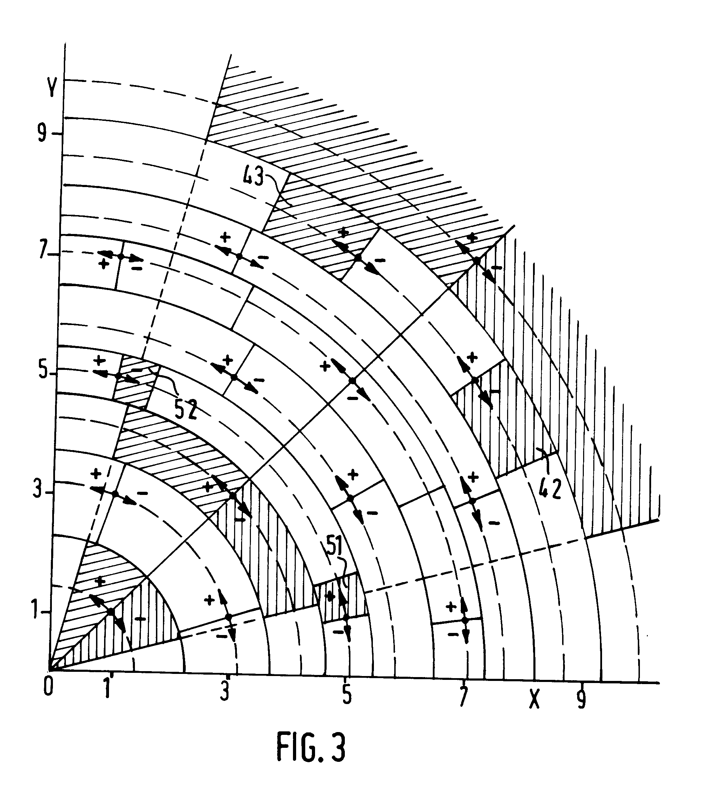

La figure 3 représente la même situation que celle de la figure 2 mais avec une borne $\theta$ encore plus importante. En effet, lorsque $\theta$ atteint 2 arc tan(1/5) = 22,62° des nouvelles zones de sélection 51, 52 apparaissent attenantes aux états (5, 1) et (1, 5) de la même manière que pour le cas précédent.

Ainsi pour le quart de plan lorsque $\theta \leq 18,92°$ les zones de sélection utilisables sont représentées sur la figure 1. Lorsque $18,92° < \theta \leq 22,62°$ les zones de sélection utilisables sont représentées sur la figure 2. Lorsque $22,62° < \theta \leq 28,07°$ = 2[45°-arc tan(3/5)] les zones de sélection utilisables sont représentées sur la figure 3.

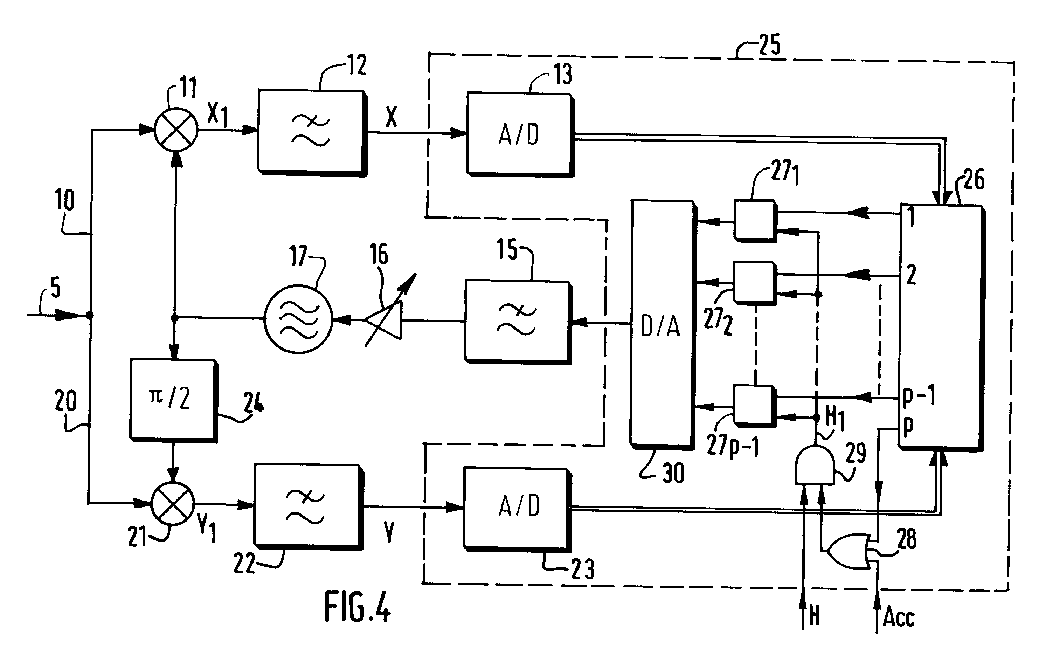

La figure 4 représente le schéma-bloc du circuit de récupération de l'onde porteuse. L'onde modulée numériquement arrive sur la connexion d'entrée 5 et se subdivise en deux voies 10 et 20 respectivement en phase et en quadrature avec l'onde de l'oscillateur 17. Celui-ci délivre son signal directement au démodulateur 11 de la voie en phase, et également au démodulateur 21 de la voie en quadrature à travers le déphaseur de $\pi/2$ 24. Les sorties des démodulateurs 11 et 21 sont filtrées respectivement dans les filtres passe-bas 12 et 22 ayant pour signal de sortie respectivement X et Y. Ces signaux pénêtrent dans le dispositif de comparaison de phase 25, respectivement dans deux convertisseurs analogiques-numériques 13, 23, qui délivrent des données qui adressent une mémoire PROM 26. Celle-ci délivre p bits dont p-1 bits sont stockés dans des bascules $27_1$, $27_2$ ... $27_{p-1}$. Ces p-1 bits forment un codage du signe et de l'amplitude de l'erreur de phase estimée. Le $p^{ième}$ bit $p_p$ détermine si le point reçu déterminé par ses coordonnées X, Y appartient ou non à une zone de sélection choisie. Le $p^{ième}$ bit entre dans une porte OU 28 qui reçoit un signal ACC qui détermine si le circuit de récupération de l'onde porteuse se trouve en mode permanent (accrochage) (ACC = 1) ou en acquisition (décrochage) (ACC = 0). En effet, le circuit de récupération selon l'invention opère en détecteur de phase en mode permanent (ACC = 1). En mode de d'acquisition (ACC = 0) il opère en détecteur de fréquence. Pour cela la sortie de la porte logique OU 28 entre dans une porte logique ET 29 avec l'horloge de base H. Ainsi le signal H1 à la sortie de la porte logique ET 29 est la copie de l'horloge H lorsque ACC = 1. Par contre lorsque ACC = 0 les fronts sont validés si $p_p$ = 1 et supprimés si $p_p$ = 0.

Ce signal H1 constitue l'horloge pour les bascules $27_1$ à $27_{p-1}$. Ainsi les p-1 bits que la mémoire 26 délivre à chaque coup d'horloge H sont stockés dans les bascules. Celles-ci conservent leurs informations pendant toute la durée où ACC = 0 et $p_p$ = 0.

Toutes les sorties des p-1 bascules entrent dans un convertisseur numérique-analogique 30 qui délivre un signal qui passe dans un filtre passe-bas 15 puis dans un amplificateur 16 pour fournir un signal de commande $\epsilon(\phi)$ qui contrôle l'oscillateur 17. Il est bien évidemment possible à l'homme du métier d'inverser l'état logique des signaux et de changer en conséquence le type de porte logique utilisé.

La particularité du dispositif de comparaison de phase 25 selon l'invention est de pouvoir opérer en détecteur de fréquence lorsque ACC = 0 et en détecteur de phase lorsque ACC = 1.

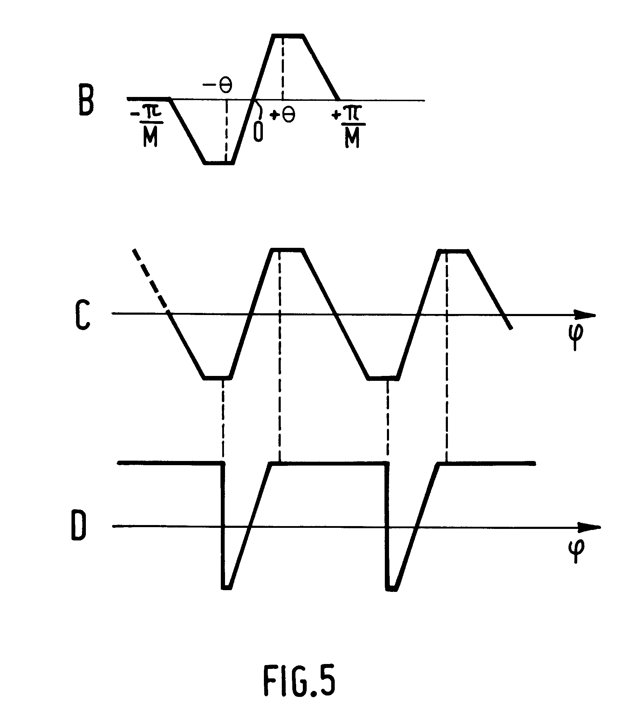

La figure 5 représente en B les caractéristiques d'un comparateur de phase pour une phase comprise entre $-\pi/M$ et $+\pi/M$. De part et d'autre du point 0 (écart de phase nul), le comparateur de phase délivre une tension fonction de l'écart de phase qui permet d'asservir la fréquence de l'oscillateur. La tension de sortie du comparateur est représentée en C. La valeur moyenne de cette tension de sortie est nulle. Pour effectuer la correction de fréquence de l'oscillateur, on stocke la valeur de l'écart de phase à l'aide du dispositif de comparaison de phase qui caractérise l'invention. Lorsque la valeur absolue de l'écart de phase dépasse la borne $\theta$ ce qui correspondant au franchissement de la zone de sélection choisie, les bascules stockent l'état du signal de sortie de la mémoire. Un tel signal stocké est représenté en D, sa valeur moyenne n'est plus nulle. Elle permet d'effectuer la correction de fréquence de l'oscillateur. Les courbes C et D de la figure 5 sont représentatives d'un écart de fréquence positif c'est-à-dire une fréquence de porteuse d'onde modulée plus grande que la fréquence de l'oscillateur. Pour un écart de fréquence négatif les courbes C et D présentent une allure inversée.

**Revendications**

1. Circuit de récupération de l'onde porteuse d'une onde modulée numériquement de symétrie de phase 2π/M, où M est l'ordre de la symétrie de la constellation des états, muni de moyens d'acquisition automatiques et rapides comprenant un oscillateur (17) commandable en tension ayant une sortie délivrant ladite onde porteuse et une entrée de commande sur laquelle est appliqué un signal d'erreur $\epsilon(\phi)$ afin de modifier la phase de l'oscillateur et l'asservir à celle de l'onde modulée numériquement, celle-ci étant introduite :

    . sur une première voie (10) comprenant en série :
    - un démodulateur (11) recevant l'onde modulée et la sortie de l'oscillateur (17), le démodulateur (11) étant suivi d'un filtre passe-bas (12) qui délivre un signal filtré X,
    . sur une seconde voie (20) comprenant en série :
    - un déphaseur à 90° (24) du signal de l'oscillateur (17),
    - un démodulateur (21) recevant l'onde modulée et la sortie du déphaseur (24), le démodulateur (21) étant suivi d'un filtre passe-bas (22) qui délivre un signal filtré Y,

les deux voies entrant avec une horloge de base H (horloge symbole récupérée), dans un dispositif de comparaison de phase (25) qui détermine un signal de comparaison et le valide à l'aide d'une horloge d'échantillonnage à cadence variable qui reproduit l'horloge de base H en excluant certains fronts, le signal de comparaison étant mémorisé puis introduit dans un filtre amplificateur (15, 16) qui délivre le signal d'erreur $\epsilon(\phi)$ de commande de l'oscillateur (17), la représentation graphique des états d'une constellation étant définis en coordonnées polaires par la fonction F(A,Φ) où A est l'amplitude et Φ la phase de chaque point de la constellation, et $\phi$ étant l'écart de phase entre l'onde modulée reçue et le point de la constellation correspondant, caractérisé en ce que le dispositif de comparaison de phase (25) opère soit en détecteur de phase soit en détecteur de fréquence à l'aide d'un signal externe d'accrochage/décrochage ACC et pour cela comprend des moyens de sélection (26, 27, 28, 29) des points reçus à l'aide de zones de sélection attenantes à certains états de la constellation, les zones, formant des portions d'anneaux, étant déterminées par l'intersection :

- premièrement des secteurs angulaires (-$\theta$, +$\theta$) correspondant à un écart de phase $\phi$ entre l'onde modulée reçue et le point de la constellation correspondant, tel que valeur absolue de $\phi < \theta$ où $\theta$ est une borne prédéterminée, chaque secteur ayant un axe de symétrie (34) passant par les états diagonaux de la constellation, ces zones étant attenantes aux états diagonaux de la constellation pour lesquels il n'existe dans un quart de plan qu'un seul état ayant une amplitude A donnée,
- avec deuxièmement des cercles frontières (31, 40), centrés sur l'origine de la constellation, de rayon

$$\frac{A1+A2}{2},$$

équidistants de deux cercles consécutifs joignant des états, l'un passant par les états à amplitude constante A1 et l'autre passant par les états à amplitude constante A2 consécutive, formant ainsi des anneaux, le point origine formant le cercle le plus intérieur, la frontière (cercle) extérieure étant bornée par l'amplitude maximale du signal détecté,

les signaux X et Y servant à adresser une mémoire (26) qui contient des informations d'appartenance se rapportant aux points reçus appartenant auxdites zones, le dispositif (25) comprenant en outre des moyens (28, 29) de génération de l'horloge d'échantillonnage qui, en mode d'acquisition (décrochage) ne valident l'horloge de base H que pour ces zones sélectionnées et qui, en mode permanent (accrochage), valident tous les fronts de l'horloge H pour former l'horloge d'échantillonnage.

2. Circuit de récupération selon la revendication 1, caractérisé en ce que pour une onde modulée numériquement de type MAQ 64, les zones de sélection sont attenantes à au moins un des états (±1, ±1), (±3, ±3), (±7, ±7).

3. Circuit de récupération selon une des revendications 1 ou 2, caractérisé en ce que dans le cas des états de la constellation pour lesquels l'angle minimum entre deux états adjacents sur le même cercle est inférieur à $\pi/2$, l'écart de phase tel que valeur absolue de $\phi < \theta$ est pris en compte, c'est-à-dire que la zone est sélectionnée, lorsque les signes de l'écart de phase sont les mêmes pour ces deux états adjacents.

4. Circuit de récupération selon les revendications 2 et 3, caractérisé en ce que les zones de sélection sont attenantes à au moins un des états (±5, ±7), (±7, ±5).

5. Circuit de récupération selon la revendication 4, caractérisé en ce que les zones de sélection sont attenantes à au moins un des états (±5, ±1), (±1, ±5).

6. Circuit de récupération selon une des revendications 1 à 5, caractérisé en ce que la mémoire (26) contient, pour les zones sélectionnées, des amplitudes et des signes de correction d'erreur à mettre en oeuvre.

7. Circuit de récupération selon la revendication 6, caractérisé en ce que le dispositif de comparaison de phase (25) comprend deux convertisseurs (12, 13) analogique-numérique placés respectivement sur les voies en phase (10) et en quadrature (20) aiin de recevoir les coordonnées cartésiennes X et Y du point reçu, les deux convertisseurs délivrant des données qui adressent la mémoire (26) dont la sortie délivre p bits, l'un des bits étant un bit d'appartenance du point reçu à l'une des zones sélectionnées qui active une entrée d'une porte logique OU (28) dont l'autre entrée reçoit le signal externe d'accrochage/décrochage ACC, la sortie de la porte OU (28) entrant dans une porte ET (29) avec l'horloge de base H aiin d'en supprimer les fronts lorsque, dans le mode d'acquisition le point reçu n'est pas dans une zone sélectionnée, et d'en valider tous les fronts dans l'état permanent, afin de constituer l'horloge d'échantillonnage qui active p-1 bascules ($27_1$...$27_{p-1}$) qui reçoivent les p-1 bits issus de la mémoire (26), les sorties des bascules actionnant un convertisseur numérique-analogique (30) qui délivre le signal d'erreur qui agit sur l'oscillateur (17) à travers le filtre amplificateur (15, 16).

8. Circuit de récupération selon une des revendications 6 ou 7, caractérisé en ce que la mémoire (26) est une mémoire PROM.

9. Circuit de récupération selon une des revendications 6 à 8, caractérisé en ce que la mémoire (26) délivre p = 2 bits, l'un pour la validation et l'autre pour donner le signe de l'écart de phase à amplitude constante.

10. Circuit de récupération selon une des revendications 6 à 8, caractérisé en ce que la mémoire (26) délivre p = 3 bits, l'un pour la validation et les deux autres pour donner l'amplitude et le signe de l'écart de phase.

**Claims**

1. Circuit for recovering the carrier of a digitally modulated wave having a phase symmetry $2\pi/M$, where M is the symmetry order of the constellation of the states, including fast automatic acquisition means comprising a voltagecontrolled oscillator (17) having an output supplying said carrier and a control input to which an error signal $\epsilon(\phi)$ is applied in order to change the oscillator phase and adjust it to the phase of said digitally modulated wave, said wave being introduced:

. into a first channel (10) comprising the series arrangement of:
 - a demodulator (11) receiving the modulated wave and the output signal of oscillator (17), the demodulator (11) being followed by a low-pass filter (12) which produces a filtered signal X,

. into a second channel (20) comprising the series arrangement of:
 - a phase shifter (24) for shifting the phase of the signal of oscillator (17) through 90°
 - a demodulator (21) receiving the modulated wave and the output signal of phase shifter (24), the demodulator (21) being followed by a low-pass filter (22) which produces a filtered signal Y,

the two channels with a basic clock H (recovered clock symbol) entering a phase comparator arrangement (25) which determines a comparator signal and validates same with the aid of a variable rate sampling clock which reproduces the basic clock H by discarding certain edges, the comparator signal being stored and then introduced into an amplifying filter (15, 16) which produces the error signal $\epsilon(\phi)$ that controls the oscillator (17), the graphic representation of the states of a signal constellation being defined in polar coordinates by the function F(A,Φ) where A is the amplitude and Φ the phase of each signal point of the constellation, and $\phi$ is the phase difference between the received modulated wave and the corresponding signal point of the constellation, characterized in that the phase comparator arrangement (25) operates alternately as a phase detector and as a frequency detector with the aid of an external locked/unlocked signal ACC and thereto comprises means (26, 27, 28, 29) for selecting received signal points with the aid of selection zones contiguous to certain states of the signal constellation, the zones forming ring segments and being determined by the intersection:

 - first, of the angular sections $(-\theta, +\theta)$ corresponding to a phase difference $\phi$ between the received modulated wave and the corresponding signal point of the constellation, so that the absolute value of $\phi$ is less than $\theta$ where $\theta$ is a preset boundary value, each section having a symmetry axis (34) passing through the diagonal states of the signal point constellation, these zones being contiguous to the diagonal states of the signal constellation for which zones in a quarter of the plane there is only a single state having a given amplitude A,
 - secondly, of the boundary circles (31, 40), centred at the origin of the signal constellation, of radius $(A1+A2)/2$, the circles being equidistant from two consecutive circles that join the states together, the one passing through the states at the constant amplitude A1 and the other passing through the states at the consecutive constant amplitude A2, thus forming rings, the point of origin forming the innermost circle, the outside boundary (circle) being restricted by the maximum amplitude of the detected signal,

the signals X and Y being used for addressing a memory (26) which contains information signals belonging to the signal points received in said zones, the arrangement (25) further including sampling clock generating means (28, 29) which, in the acquisition mode (unlocked), validate the basic clock H only for these selected zones and which, in the permanent mode (locked), validate all the edges of the clock H for forming the sampling clock.

2. Recovery circuit as claimed in Claim 1, characterized in that for a digitally modulated wave of the 64 QAM type, the selection zones are contiguous to at least one of the states (±1,±1), (±3,±3), (±7,±7).

3. Recovery circuit as claimed in one of the Claims 1 or 2, characterized in that in the case where the states of the signal constellation for which the minimum angle between two contiguous states in the same circle is less than $\pi/2$, the phase difference as well as the absolute value of $\phi < \theta$ is taken into account, that is to say that the zone is selected, when the signs of the phase difference are the same for these two contiguous states.

**4.** Recovery circuit as claimed in the Claims 2 and 3, characterized in that the selection zones are contiguous to at least one of the states $(\pm 5, \pm 7)$, $(\pm 7, \pm 5)$.

**5.** Recovery circuit as claimed in Claim 4, characterized in that the selection zones are contiguous to at least one of the states $(\pm 5, \pm 1)$, $(\pm 1, \pm 5)$.

**6.** Recovery circuit as claimed in one of the Claims 1 to 5, characterized in that the memory (26) contains for the selected zones amplitudes and error correction signs to be used.

**7.** Recovery circuit as claimed in Claim 6, characterized in that the phase comparator arrangement (25) comprises two analog-to-digital converters (12, 13) inserted in the in-phase channel (10) and the quadrature channel (20) respectively, so as to receive the cartesian coordinates X and Y of the received signal point, the two converters producing data that address a memory (26) whose output produces p bits, one of the bits belonging to the received signal point in one of the selected zones which enables an input of a logic OR gate (28) whose other input receives an external locked/unlocked signal (ACC), the output signal of the OR gate (28) entering an AND gate (29) with the basic clock H so as to suppress the edges thereof when, in the acquisition mode, the received signal point is not situated in a selected zone, and to validate thereof all the edges in the permanent state, in order to form the sampling clock that activates p-1 bistable triggers $(27_1, ..., 27_{p-1})$ which receive the p-1 bits from the memory (26), the output signals of the bistable triggers driving a digital-to-analog converter (30) which produces the error signal that acts on the oscillator (17) through the amplifying filter (15, 16).

**8.** Recovery circuit as claimed in one of the Claims 6 or 7, characterized in that the memory (26) is a PROM memory.

**9.** Recovery circuit as claimed in one of the Claims 6 to 8, characterized in that the memory (26) produces p = 2 bits, one for the validation and the other for providing the constant amplitude phase difference sign.

**10.** Recovery circuit as claimed in one of the Claims 6 to 8, characterized in that the memory (26) produces p = 3 bits, one for the validation and the other two for providing the amplitude and the phase difference sign.

**Patentansprüche**

**1.** Schaltungsanordnung zur Regenerierung des Trägers einer digital modulierten Welle mit einer symmetrischen Phase $2\pi/M$, wobei M die Symmetheordnung der Konstellation der Zustände ist, mit Mitteln zum schnellen automatischen Zugriff mit einem spannungsgeregelten Oszillator (17) mit einem Ausgang, der den genannten Träger liefert und mit einem Regeleingang, dem ein Fehlersignal $\epsilon(\phi)$ zugeführt wird zum Ändern der Oszillatorphase und zum Einstellen derselben auf die Phase der genannten digital modulierten Welle, wobei die Welle in die nachfolgenden Elemente eingeführt wird:

. in einen ersten Kanal (10) mit der Reihenschaltung aus den nachfolgenden Elementen:
- einem Demodulator (11), der die modulierte Welle und das Ausgangssignal des Oszillators (17) erhält, wobei dem Demodulator (11) ein Tiefpaßfilter (12) nachgeschaltet ist, das ein gefiltertes Signal X liefert,

. in einen zweiten Kanal (20) mit der Reihenschaltung aus den nachfolgenden Elementen:
- einem 90°-Phasenschieber (24) zum Verschieben der Phase des Oszillatorsignals,
- einem Demodulator (21), der die modulierte Welle und das Ausgangssignal des Phasenschiebers (24) erhält, wobei dem Demodulator (21) ein Tiefpaßfilter (22) nachgeschaltet ist, das ein gefiltertes Signal Y liefert,

wobei die zwei Kanäle mit einem Basis-Taktimpuls H (regeneriertes Taktimpulssymbol) zu einer Phasenvergleichsanordnung (25) führen, die ein Vergleichssignal bestimmt und dieses bewertet mit Hilfe eines Abtasttaktimpulses mit veränderlicher Taktgeschwindigkeit, der den Basis-Taktimpuls H unter Ausschließung bestimmter Flanken wiedergibt, wobei das Vergleichssignal gespeichert und danach in ein Verstärkungsfilter (15, 16) eingeführt wird, das das Fehlersignal $\epsilon(\phi)$ der Regelung des Oszillators (17) liefert, wobei die graphische Darstellung der Zustände einer Konstellation durch die Funktion $F(A,\Phi)$ in Polkoordinaten definiert wird, wobei A die Amplitude und $\Phi$ die Phase jedes Signalpunktes der Konstellation ist und wobei $\phi$ die Phasendifferenz zwischen der empfangenen modulierten Welle und dem entsprechenden Punkt der Konstellation ist, dadurch gekennzeichnet, daß die Phasenvergleichsanordnung (25) mit Hilfe eines äußeren Verriegelungs-/Entriegelungssignals ACC entweder als Phasendetektor oder als Frequenzdetektor wirksam ist und dazu Mittel (26, 27, 28, 29) aufweist zum Selektieren der empfangenen Signalpunkte mit Hilfe von Selektionszonen, die bestimmten Zuständen der Signalkonstellation zugeordnet sind, wobei diese Zonen Ringsegmente bilden und bestimmt werden durch den Schnittpunkt:

- von, erstens, den Winkelabschnitten ($-\theta$, $+\theta$) entsprechend einer Phasendifferenz $\phi$ zwischen der empfangenen modulierten Welle und dem entsprechenden Signalpunkt der Konstellation, derart, daß der Absolutwert von $\phi$ kleiner ist als $\theta$, wobei $\theta$ eine voreingestellte Eegrenzung ist, wobei jeder Abschnitt eine Symmetrieachse (34) aufweist, die durch die diagonalen Zustände der Signalkonstellation geht, wobei diese Zonen um die diagonalen Zustände der Signalkonstellation liegen, wobei es für die Zonen in einer Viertelfläche nur einen einzigen Zustand mit einer gegebenen Amplitude A gibt,

- mit zweitens, den Begrenzungskreisen (31, 40), zentriert um den Ursprung der Konstellation mit einem Radius $\frac{1}{2}$(A1 + A2), wobei die Kreise in gleichem Abstand von zwei weiteren Kreisen liegen, welche die Zustände koppeln, wobei der eine Kreis durch die Zustände mit konstanter Amplitude A1 geht und der andere durch die Zustände mit weiterer konstanter Amplitude A2 geht, wodurch Ringe gebildet werden, wobei der Ursprung der innere Kreis bildet, wobei der äußere Begrenzungskreis durch die maximale Amplitude des detektierten Signal begrenzt wird,

wobei die Signale X und Y zum Adressieren eines Speichers (26) dienen, der Zuordnungsinformation enthält, die sich bezieht auf empfangene Signalpunkte, die den genannten Zonen zugeordnet sind, wobei die Anordnung (25) weiterhin Abtasttaktimpulserzeugungsmittel (28, 29) aufweist, die in der Zugriff-Betriebsart (Entriegelung) den Basis-Taktimpuls H nur für diese selektierten Zonen bewerten und die in der permanenten Betriebsart (Verriegelung) alle Flanken des Taktimpulses H bewerten zum Bilden des Abtast-Taktimpulses.

2.  Regenerationsschaltung nach Anspruch 1, dadurch gekennzeichnet, daß für eine digital modulierte Welle vom QAM 64 Typ die Selektionszonen um mindestens einen der Zustände (±1, ±1), (±3, ±3), (±7, ±7) herum liegen.

3.  Regenerationsschaltung nach einem der Ansprüche 1 oder 2, dadurch gekennzeichnet, daß in dem Fall der Zustände der Konstellation, für die der minimale Winkel zwischen zwei benachbarten Zuständen auf demselben Kreis Kleiner ist als $\pi/2$, die Phasenabweichung sowie der Absolutwert von $\phi < \theta$ berücksichtigt wird, d.h. daß die Zone gewählt wird, wenn die Vorzeichen der Phasenabweichung für diese beiden benachbarten Zustände dieselben sind.

4.  Regenerationsschaltung nach den Ansprüchen 2 und 3, dadurch gekennzeichnet, daß die Selektionszonen um mindestens einen der Zustände (±5, ±7), (±7, ±5) herum liegen.

5.  Regenerationsschaltung nach Anspruch 4, dadurch gekennzeichnet, daß die Selektionszonen um mindestens einen der Zustände (±5, ±1), (±1, ±5) herum liegen.

6.  Regenerationsschaltung nach einem der Ansprüche 1 bis 5, dadurch gekennzeichnet, daß der Speicher (26) für die gewählten Zonen Amplituden und Vorzeichen zum Durchführen von Fehlerkorrekturen enthält.

7.  Regenerationsschaltung nach Anspruch 6, dadurch gekennzeichnet, daß die Phasenvergleichsanordnung (25) zwei Analog-Digital-Wandler (12, 13) aufweist, die in der phasengleichen Strecke (10) bzw. in der Quadraturstrecke (20) vorgesehen sind um die Karthesischen Koordinaten X und Y des empfangenen Signalpunktes zu erhalten, wobei diese beiden Wandler Daten liefern, die den Speicher (26) adressieren, dessen Ausgang p Bits liefert, wobei eines der Bits ein Zugehörigkeits-Bit des empfangenen Punktes zu einer der selektierten Zonen ist, das einen Eingang eines logischen ODER-Gatters (28) aktiviert, dessen anderer Eingang ein externes Verriegelungs-/Entriegelungssignal ACC erhält, wobei das Ausgangssignal des ODER-Gatters (28) mit dem Basistaktimpuls H einem UND-Gatter (29) zugeführt wird, um die Flanken zu unterdrücken, wenn in der Zugriffsbetriebsart der empfangene Signalpunkt in einer Selektionszone nicht vorhanden ist, und um alle Flanken zu bewerten in dem ständigen Zustand, zum Bilden des Abtast-Taktimpulses, der p-1 bistabile Triggerschaltungen ($27_1 \ldots 27_{p-1}$ aktiviert, welche die p-1 Bits von dem Speicher (26) erhalten, wobei die Ausgangssignale der bistabilen Triggerschaltungen einen Digital-Analog-Wandler (30) betreiben, der das Fehlersignal liefert, das über das Verstärkungsfilter (15, 16) den Oszillator (17) beeinflußt.

8. Regenerationsschaltung nach einem der Ansprüche 6 oder 7, dadurch gekennzeichnet, daß der Speicher (26) ein PROM-Speicher ist.

9. Regenerationsschaltung nach einem der Ansprüche 6 bis 8, dadurch gekennzeichnet, daß der Speicher (26) $p = 2$ Bits liefert, das eine zum Bewerten und das andere zum Liefern des Vorzeichens der Phasenabweichung bei konstanter Amplitude.

10. Regenerationsschaltung nach einem der Ansprüche 6 bis 8, dadurch gekennzeichnet, daß der Speicher (26) $p = 3$ Bits liefert, das eine zum Bewerten und die beiden anderen zum Liefern der Amplitude und des Vorzeichens der Phasenabweichung.

FIG.1

FIG.2

FIG. 3

FIG.4

FIG.5